# EUROPEAN PATENT SPECIFICATION

(11) **EP 3 817 055 B1**
(45) Date of publication and mention of the grant of the patent: **10.01.2024**
(21) Application number: 20174720.1
(22) Date of filing: 14.05.2020
(51) Int. Cl.: H10B 61/00

(54) **MRAM ARRAY WITH DUMMY MAGNETIC TUNNELING JUNCTIONS**
MRAM-ARRAY MIT DUMMY-MAGNETTUNNELÜBERGÄNGEN
RÉSEAU MRAM AVEC JONCTIONS FACTICES À EFFET TUNNEL MAGNÉTIQUE

(30) Priority: 04.11.2019 CN 201911064575
(43) Date of publication of application: 05.05.2021
(73) Proprietor: United Microelectronics Corp., Hsin-Chu City 300 (TW)
(72) Inventor: WANG, Hui-Lin, Taipei City 108 (TW); HSU, Po-Kai, Tainan City 701 (TW); JHANG, Jing-Yin, Tainan City 710 (TW); CHEN, Hung-Yueh, Hsinchu City 300 (TW); WANG, Yu-Ping, Hsinchu City 300 (TW); WU, Jia-Rong, Kaohsiung City 832 (TW); HUANG, Rai-Min, Taipei City 111 (TW); TSAI, Ya-Huei, Tainan City 708 (TW); CHANG, I-Fan, Hsinchu City 300 (TW)
(74) Representative: Isarpatent

(56) References cited:
- US-A1- 2007 164 265
- US-A1- 2011 073 917
- US-A1- 2012 063 216
- US-A1- 2016 071 905
- US-A1- 2016 104 745
- US-A1- 2019 206 928

## Description

### Background of the Invention

### 1. Field of the Invention

The invention relates to magnetoresistive random access memory (MRAM) devices and fabrication thereof.

### 2. Description of the Prior Art

Magnetoresistance (MR) effect has been known as a kind of effect caused by altering the resistance of a material through variation of outside magnetic field. The physical definition of such effect is defined as a variation in resistance obtained by dividing a difference in resistance under no magnetic interference by the original resistance. Currently, MR effect has been successfully utilized in production of hard disks thereby having important commercial values. Moreover, the characterization of utilizing GMR materials to generate different resistance under different magnetized states could also be used to fabricate MRAM devices, which typically has the advantage of keeping stored data even when the device is not connected to an electrical source.

The aforementioned MR effect has also been used in magnetic field sensor areas including but not limited to for example electronic compass components used in global positioning system (GPS) of cellular phones for providing information regarding moving location to users. Currently, various magnetic field sensor technologies such as anisotropic magnetoresistance (AMR) sensors, GMR sensors, magnetic tunneling junction (MTJ) sensors have been widely developed in the market. Nevertheless, most of these products still pose numerous shortcomings such as high chip area, high cost, high power consumption, limited sensibility, and easily affected by temperature variation and how to come up with an improved device to resolve these issues has become an important task in this field. Document US 2012/0063216 A1 discloses an MRAM array comprising magnetic tunneling junctions and dummy magnetic tunneling junctions between the magnetic tunneling junctions, wherein the dummy junctions have no top or bottom metal interconnection. A similar arrangement is known from US 2016/0104745 A1. Document US 2011/0073917 A1 discloses another similar memory structure with active and dummy junctions, the active junctions leading through a buffer layer to connect to an active via. US 2016/0071905 A1 features a dielectric cap layer formed on the surface of active and dummy MTJs, the latter having top and bottom plug interconnections.

### Summary of the Invention

According to an embodiment of the present invention, an MRAM device includes a first magnetic tunneling junction (MTJ) and a second MTJ on a substrate and a dummy MTJ between the first MTJ and the second MTJ, in which a bottom surface of the dummy MTJ is not connected to any metal. A top electrode is formed on the MTJs and the dummy MTJ; and a cap layer is formed around the dummy MTJ, the first MTJ, and the second MTJ, the cap layer covering the entire top surface of the top electrode on the dummy MTJ directly. Preferably, the device further includes a first metal interconnection under the first MTJ, a second metal interconnection under the second MTJ, and a first inter-metal dielectric (IMD) layer around the first metal interconnection and the second metal interconnection and directly under the dummy MTJ.

According to another embodiment of the present invention, an MRAM device includes: a first magnetic tunneling junction (MTJ) and a second MTJ on a substrate, wherein the first MTJ is immediately adjacent to the second MTJ; a first dummy MTJ adjacent to one side of the first MTJ; and a second dummy MTJ adjacent to one side of the second MTJ. A top electrode is formed on each of the MTJs and dummy MTJs. A cap layer is formed around the first and second dummy MTJs, the first MTJ, and the second MTJ, the cap layer covering the entire top surface of the top electrode on the dummy MTJs directly. The bottom surfaces of the first dummy MTJ and the second dummy MTJ are not connected to any metal.

These and other objectives of the present invention will no doubt become obvious to those of ordinary skill in the art after reading the following detailed description of the preferred embodiment that is illustrated in the various figures and drawings.

### Brief Description of the Drawings

Fig. 1 illustrates a top view for fabricating an MRAM device according to an embodiment of the present invention.
Fig. 2 illustrates a cross-section view of Fig. 1 along the sectional line AA' for fabricating the device.
Fig. 3 illustrates a cross-section view of Fig. 1 along the sectional line BB' for fabricating the device.
Fig. 4 illustrates a structural view of a device taken along the sectional line AA' of Fig. 1 according to an embodiment of the present invention.
Fig. 5 illustrates a structural view of a device taken along the sectional line BB' of Fig. 1 according to an embodiment of the present invention.

### Detailed Description

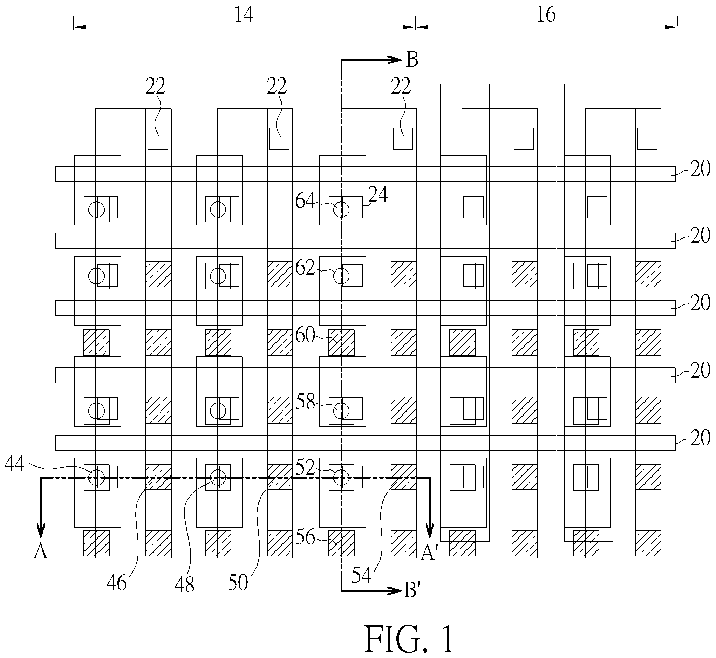

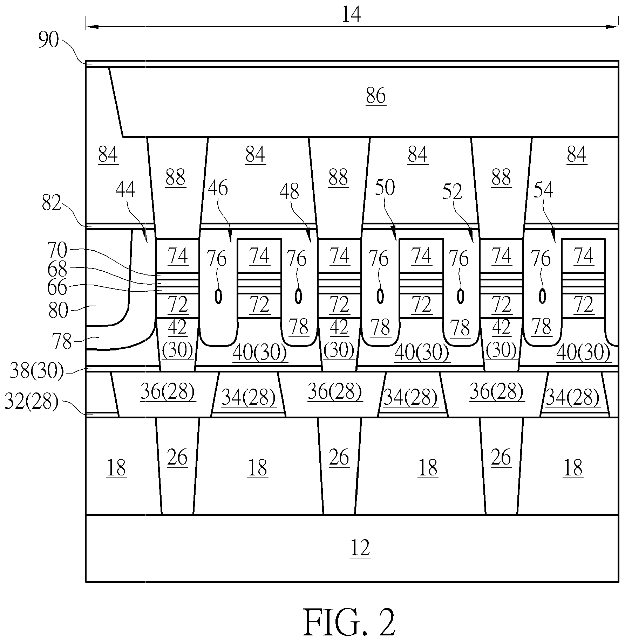

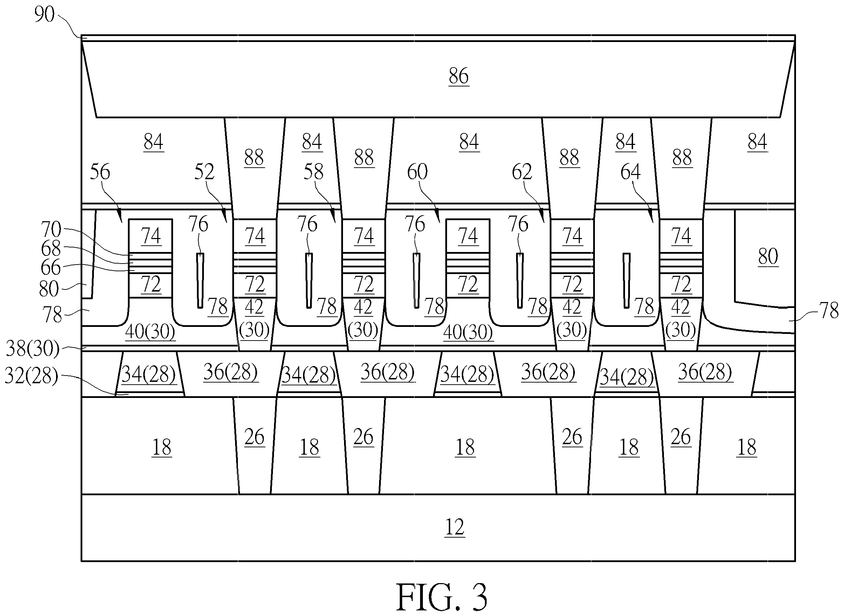

Referring to Figs. 1-3, Fig. 1 illustrates a top view for fabricating an MRAM device according to an embodiment of the present invention, Fig. 2 illustrates a cross-section view of Fig. 1 along the sectional line AA' for fabricating the device, and Fig. 3 illustrates a cross-section view of Fig. 1 along the sectional line BB' for fabricating the device. As shown in Figs. 1-3, a substrate 12 made of semiconductor material is first provided, in which the semiconductor material could be selected from the group consisting of silicon (Si), germanium (Ge), Si-Ge compounds, silicon carbide (SiC), and gallium arsenide (GaAs), and an MTJ region 14 and a logic region 16 are defined on the substrate 12.

Active devices such as metal-oxide semiconductor (MOS) transistors, passive devices, conductive layers, and interlayer dielectric (ILD) layer 18 could also be formed on top of the substrate 12. More specifically, planar MOS transistors or non-planar (such as FinFETs) MOS transistors could be formed on the substrate 12, in which the MOS transistors could include transistor elements such as gate structures 20 (for example metal gates) and source regions 22, drain regions 24, spacers, epitaxial layers, and contact etch stop layer (CESL). The ILD layer 18 could be formed on the substrate 12 to cover the MOS transistors, and a plurality of contact plugs 26 could be formed in the ILD layer 18 to electrically connect to the gate structures 20 and/or source regions 22 and drain regions 24 of MOS transistors. Since the fabrication of planar or non-planar transistors and ILD layer is well known to those skilled in the art, the details of which are not explained herein for the sake of brevity.

Next, metal interconnect structures 28, 30 are sequentially formed on the ILD layer 18 on the MTJ region 14 and the edge region 16 to electrically connect the aforementioned contact plugs 26, in which the metal interconnect structure 28 includes a stop layer 32 disposed on the ILD layer 18, an inter-metal dielectric (IMD) layer 34, and metal interconnections 36 embedded in the IMD layer 34, and the metal interconnect structure 30 includes a stop layer 38, an IMD layer 40, and metal interconnections 42 embedded in the stop layer 38 and the IMD layer 40.

In this embodiment, each of the metal interconnections 36 from the metal interconnect structure 28 preferably includes a trench conductor and each of the metal interconnections 42 from the metal interconnect structure 30 on the MTJ region 14 includes a via conductor. Preferably, each of the metal interconnections 36, 42 from the metal interconnect structures 28, 30 could be embedded within the IMD layers 34, 40 and/or stop layer 32, 38 according to a single damascene process or dual damascene process. For instance, each of the metal interconnections 36, 42 could further includes a barrier layer and a metal layer, in which the barrier layer could be selected from the group consisting of titanium (Ti), titanium nitride (TiN), tantalum (Ta), and tantalum nitride (TaN) and the metal layer could be selected from the group consisting of tungsten (W), copper (Cu), aluminum (Al), titanium aluminide (TiAl), and cobalt tungsten phosphide (CoWP). Since single damascene process and dual damascene process are well known to those skilled in the art, the details of which are not explained herein for the sake of brevity. In this embodiment, the metal interconnections 36 are preferably made of copper, the metal interconnections 42 are made of tungsten, the IMD layers 34, 40 are preferably made of silicon oxide, and the stop layers 32, 38 are preferably made of nitrogen doped carbide (NDC), silicon nitride, silicon carbon nitride (SiCN), or combination thereof.

Next, an MTJ stack (not shown) or stack structure is formed on the metal interconnect structure 30, and one or more photo-etching process is conducted to remove part of the MTJ stack to form a plurality of MTJs such as MTJs 44, 48, 52, 58, 62, 64 and a plurality of dummy MTJs such as dummy MTJs 46, 50, 54, 56, 60 on the MTJ region 14, in which each of the MTJs 44, 48, 52, 58, 62, 64 is disposed on the metal interconnections 42 while each of the dummy MTJs 46, 50, 54, 56, 60 is directly disposed on the IMD layer 40. It should be noted that the photo-etching process conducted to pattern the MTJ stack could be accomplished by a reactive ion etching (RIE) process and/or ion beam etching (IBE) process. Due to the characteristics of the IBE process, the top surface of the remaining IMD layer 40 is slightly lower than the top surface of the metal interconnections 42 after the IBE process and the top surface of the IMD layer 40 also reveals a curve or an arc.

Moreover, the MTJs 44, 48, 52, 58, 62, 64 and the dummy MTJs 46, 50, 54, 56, 60 formed at this stage could have different arrangements depending on the perspective of different cross-sections being taken. For instance, if viewed from an angle according to the sectional line AA' in Figs. 1-2, the MTJs 44, 48, 52 and dummy MTJs 46, 50, 54 are arranged by repeating one dummy MTJ (such as 46, 50, 54) immediately followed by one MTJ (such as 44, 48, 52). Alternatively, if viewed from an angle according to the sectional line BB' in Figs. 1 and 3, the MTJs 52, 58, 62, 64 and dummy MTJs 56, 60 are arranged by repeating one dummy MTJ (such as 56, 60) immediately followed by two MTJs (such as 52, 58, 62, 64).

In this embodiment, each of the MTJs 44, 48, 52, 58, 62, 64 and dummy MTJs 46, 50, 54, 56, 60 includes a fixed layer 66, a barrier layer 68, and a free layer 70, a bottom electrode 72 is disposed under each of the MTJs 44, 48, 52, 58, 62, 64 and dummy MTJs 46, 50, 54, 56, 60, and a top electrode 74 is disposed on top of each of the MTJs 44, 48, 52, 58, 62, 64 and dummy MTJs 46, 50, 54, 56, 60. In this embodiment, the bottom electrodes 72 and top electrodes 74 are preferably made of conductive material including but not limited to for example Ta, Pt, Cu, Au, Al, TiN, or combination thereof. The fixed layer 66 could be made of antiferromagnetic (AFM) material including but not limited to for example ferromanganese (FeMn), platinum manganese (PtMn), iridium manganese (IrMn), nickel oxide (NiO), or combination thereof, in which the fixed layer 66 is formed to fix or limit the direction of magnetic moment of adjacent layers. The barrier layer 68 could be made of insulating material including but not limited to for example oxides such as aluminum oxide (AlOₓ) or magnesium oxide (MgO). The free layer 70 could be made of ferromagnetic material including but not limited to for example iron, cobalt, nickel, or alloys thereof such as cobalt-iron-boron (CoFeB), in which the magnetized direction of the free layer 70 could be altered freely depending on the influence of outside magnetic field.

Next, a cap layer 78 and an IMD layer 80 are formed on the MTJs 44, 48, 52, 58, 62, 64 and dummy MTJs 46, 50, 54, 56, 60 to cover the IMD layer 40, and a planarizing process such as a chemical mechanical polishing (CMP) process is conducted to remove part of the IMD layer 80 so that the top surfaces of the cap layer 78 and IMD layer 80 are coplanar and higher than the top surface of the top electrodes 74. In this embodiment, the cap layer 78 preferably includes silicon nitride, but could also be made of other dielectric materials including but not limited to for example silicon oxide, silicon oxynitride (SiON), and/or silicon carbon nitride (SiCN).

Next, a stop layer 82 and another IMD layer 84 are formed on the MTJs 44, 48, 52, 58, 62, 64 and dummy MTJs 46, 50, 54, 56, 60 to cover the surface of the cap layer 78 and IMD layer 80, and one or more photo-etching process is conducted to remove part of the IMD layer 84 and part of the stop layer 82 on both MTJ region 14 and logic region 16 to form contact holes (not shown). Next, a barrier layer and a metal layer are formed to fill the contact holes completely, in which the barrier layer could include titanium (Ti), titanium nitride (TiN), tantalum (Ta), tantalum nitride (TaN), or combination thereof and the metal layer could include tungsten (W), copper (Cu), aluminum (Al), titanium aluminide (TiAl), cobalt tungsten phosphide (CoWP), or combination thereof. Next, a planarizing process such as CMP is conducted to remove part of the metal layer and part of the barrier layer to form metal interconnections 86, 88 electrically connecting the top electrodes 74 on the MTJ region 14 and other metal interconnections on the logic region 16. Next, another stop layer 90 is formed on the IMD layer 84 to cover the metal interconnections 86, 88. This completes the fabrication of a device according to an embodiment of the present invention.

Referring again to Fig. 2, Fig. 2 illustrates a structural view of a device taken along the sectional line AA' of Fig. 1 according to an embodiment of the present invention. As shown in Fig. 2, the device includes a plurality of MTJs 44, 48, 52 and a plurality of dummy MTJs 46, 50, 54 disposed on the substrate 12, a top electrode 74 disposed on each of the MTJs 44, 48, 52 and dummy MTJs 46, 50, 54, a bottom electrode 72 disposed under each of the MTJs 44, 48, 52 and dummy MTJs 46, 50, 54, metal interconnections 42 under the bottom electrodes 72 and electrically connected to the metal interconnections or contact plugs 26 disposed in lower level ILD layer 18, an IMD layer 40 surrounding the metal interconnections 42, a cap layer 78 around the MTJs 44, 48, 52 and dummy MTJs 46, 50, 54 and on the IMD layer 40, and air gaps 76 enclosed within the cap layer 78 between MTJs 44, 48, 52 and dummy MTJs 46, 50, 54.

Preferably, the arrangement of MTJs in this embodiment involves placing a dummy MTJ (46, 50, or 54) immediately adjacent to an MTJ (44, 48, or 52) and repeating such arrangement such that each of the dummy MTJs is disposed between two metal interconnections 36, in which the bottom electrode 72 under the MTJs 44, 48, 52 is directly connected to metal or metal interconnections 42 while the bottom electrodes 72 under the dummy MTJs 46, 50, 54 are not connected to or contacting any metal but instead contacting the IMD layer 40 directly. Moreover, each of the MTJs 44, 48, 52, top electrodes 74, and/or bottom electrodes 72 are preferably aligned to the metal interconnections or contact plugs 26 within the lower level ILD layer 18, in which the definition of alignment in this instance could refer to either aligning the center of each of the MTJs 44, 48, 52 to the center of each of the contact plugs 26 or aligning an edge of each of the MTJs 44, 48, 52 to an edge of each of the contact plugs 26, which are all within the scope of the present invention.

Preferably, the cap layer 78 made of silicon nitride in this embodiment is disposed to fill the space between MTJs 44, 48, 52 and dummy MTJs 46, 50, 54 so that no IMD layer is disposed between the MTJs 44, 48, 52 and dummy MTJs 46, 50, 54. The IMD layer 80 is only disposed on the cap layer 78 adjacent to the MTJ and/or dummy MTJ on the edge of the MTJ region 14, such as on the cap layer 78 left to the MTJ 44 and right to the dummy MTJ 54, and each of the air gaps 76 is surrounded by the cap layer 78 between the MTJs 44, 48, 52 and dummy MTJs 46, 50, 54.

Referring to Fig. 3, Fig. 3 illustrates a structural view of a device taken along the sectional line BB' of Fig. 1 according to an embodiment of the present invention. As shown in Fig. 3, the device includes a plurality of MTJs 52, 58, 62, 64 and a plurality of dummy MTJs 56, 60 on the substrate 12, a top electrode 74 disposed on each of the MTJs 52, 58, 62, 64 and dummy MTJs 56, 60, a bottom electrode 72 disposed under each of the MTJs 52, 58, 62, 64 and dummy MTJs 56, 60, metal interconnections 42 under the bottom electrodes 72 and electrically connected to the metal interconnections or contact plugs 26 disposed in lower level ILD layer 18, an IMD layer 40 surrounding the metal interconnections 42, a cap layer 78 around the MTJs 52, 58, 62, 64 and dummy MTJs 56, 60 and on the IMD layer 40, and air gaps 76 enclosed by the cap layer 78 between MTJs 52, 58, 62, 64 and dummy MTJs 56, 60.

Preferably, the arrangement of MTJs in this embodiment involves placing a dummy MTJ (56 or 60) immediately adjacent to two MTJs (52, 58, 62, or 64) and repeating such arrangement such that each of the dummy MTJs is disposed between two metal interconnections 36, in which the bottom electrodes 72 under the MTJs 52, 58, 62, 64 is directly connected to metal or metal interconnections 42 while the bottom electrodes 72 under the dummy MTJs 56, 60 are not connected to or contacting any metal but instead contacting the IMD layer 40 directly. Moreover, each of the MTJs 52, 58, 62, 64, top electrodes 74, and/or bottom electrodes 72 are preferably aligned to the metal interconnections or contact plugs 26 within the lower level ILD layer 18, in which the definition of alignment in this instance could refer to either aligning the center of each of the MTJs 52, 58, 62, 64 to the center of each of the contact plugs 26 or aligning an edge of each of the MTJs 52, 58, 62, 64 to an edge of each of the contact plugs 26, which are all within the scope of the present invention.

Similar to the aforementioned embodiment, the cap layer 78 made of silicon nitride in this embodiment is disposed to fill the space between MTJs 52, 58, 62, 64 and dummy MTJs 56, 60 so that no IMD layer is disposed between the MTJs 52, 58, 62, 64 and dummy MTJs 56, 60. The IMD layer 80 is only disposed on the cap layer 78 adjacent to the MTJ and/or dummy MTJ on the edge of the MTJ region 14, such as on the cap layer 78 right to the MTJ 64 and left to the dummy MTJ 56, and each of the air gaps 76 is surrounded by the cap layer 78 between the MTJs 52, 58, 62, 64 and dummy MTJs 56, 60.

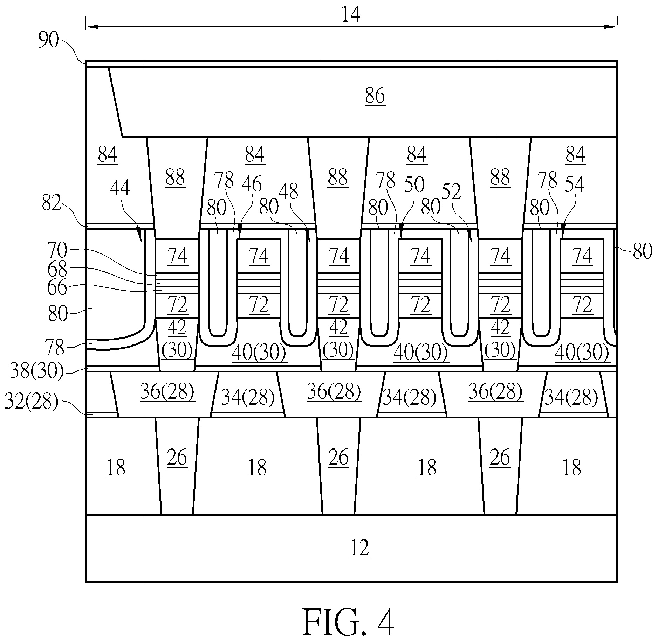

Referring to Fig. 4, Fig. 4 illustrates a structural view of a device taken along the sectional line AA' of Fig. 1 according to an embodiment of the present invention. As shown in Fig. 4, the device includes a plurality of MTJs 44, 48, 52 and a plurality of dummy MTJs 46, 50, 54 disposed on the substrate 12, a top electrode 74 disposed on each of the MTJs 44, 48, 52 and dummy MTJs 46, 50, 54, a bottom electrode 72 disposed under each of the MTJs 44, 48, 52 and dummy MTJs 46, 50, 54, metal interconnections 42 under the bottom electrodes 72 and electrically connected to the metal interconnections or contact plugs 26 disposed in lower level ILD layer 18, an IMD layer 40 surrounding the metal interconnections 42, and a cap layer 78 around the MTJs 44, 48, 52 and dummy MTJs 46, 50, 54 and on the IMD layer 40.

Preferably, the arrangement of MTJs in this embodiment involves placing a dummy MTJ (46, 50, or 54) immediately adjacent to an MTJ (44, 48, or 52) and repeating such arrangement such that each of the dummy MTJs is disposed between two metal interconnections 36. In contrast to not forming any IMD layer between the MTJs 44, 48, 52 and dummy MTJs 46, 50, 54 as disclosed in the embodiment shown in Fig. 2, a cap layer 78 and an IMD layer 80 disposed on the cap layer 78 are formed between the MTJs 44, 48, 52 and dummy MTJs 46, 50, 54.

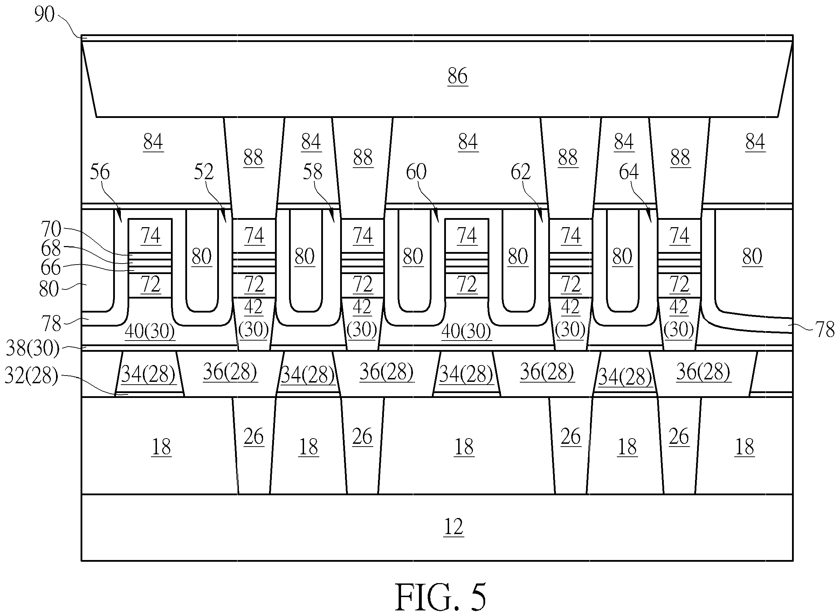

Referring to Fig. 5, Fig. 5 illustrates a structural view of a device taken along the sectional line BB' of Fig. 1 according to an embodiment of the present invention. As shown in Fig. 5, the device includes a plurality of MTJs 52, 58, 62, 64 and a plurality of dummy MTJs 56, 60 on the substrate 12, a top electrode 74 disposed on each of the MTJs 52, 58, 62, 64 and dummy MTJs 56, 60, a bottom electrode 72 disposed under each of the MTJs 52, 58, 62, 64 and dummy MTJs 56, 60, metal interconnections 42 under the bottom electrodes 72 and electrically connected to the metal interconnections or contact plugs 26 disposed in lower level ILD layer 18, an IMD layer 40 surrounding the metal interconnections 42, and a cap layer 78 around the MTJs 52, 58, 62, 64 and dummy MTJs 56, 60 and on the IMD layer 40.

Preferably, the arrangement of MTJs in this embodiment involves placing a dummy MTJ (56 or 60) immediately adjacent to two MTJs (52, 58, 62, or 64) and repeating such arrangement such that each of the dummy MTJs is disposed between two metal interconnections 36. In contrast to not forming any IMD layer between the MTJs 52, 58, 62, 64 and dummy MTJs 56, 60 as disclosed in the embodiment shown in Fig. 3, a cap layer 78 and an IMD layer 80 disposed on the cap layer 78 are formed between the MTJs 52, 58, 62, 64 and dummy MTJs 56, 60.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A magnetoresistive random access memory, MRAM, device, comprising:
a first magnetic tunneling junction, MTJ, (44, 48, 52, 58, 62) and a second MTJ (44, 48, 52, 58, 62) on a substrate (12);
a dummy MTJ (46, 50, 60) between the first MTJ and the second MTJ, wherein a bottom surface of the dummy MTJ is not connected to any metal; and
a top electrode (74) on each of the MTJs and the dummy MTJ,
**characterised by** a cap layer (78) around the dummy MTJ, the first MTJ, and the second MTJ, wherein the cap layer (78) covers the entire top surface of the top electrode on the dummy MTJ directly.

2. The MRAM device of claim 1, further comprising:
a first metal interconnection (42) under the first MTJ;
a second metal interconnection (42) under the second MTJ; and
a first inter-metal dielectric, IMD, layer (40) around the first metal interconnection and the second metal interconnection and directly under the dummy MTJ (46, 50, 60).

3. The MRAM device of claim 2, wherein the first IMD layer (40) is covered by the cap layer (78).

4. The MRAM device of one of the claims 1 to 3, wherein the cap layer (78) comprises silicon nitride.

5. The MRAM device of one of the claims 1 to 4, further comprising a first air gap (76) enclosed by the cap layer (78) between the dummy MTJ and the first MTJ.

6. The MRAM device of claim 5, further comprising a second air gap (76) enclosed by the cap layer (78) between the dummy MTJ and the second MTJ.

7. The MRAM device of claim 3, further comprising:
a second IMD layer (80) on the cap layer (78).

8. A magnetoresistive random access memory, MRAM, device, comprising:
a first magnetic tunneling junction, MTJ, (52, 58) and a second MTJ (52, 58) on a substrate (12), wherein the first MTJ is immediately adjacent to the second MTJ;
a first dummy MTJ (56, 60) adjacent to one side of the first MTJ;
a second dummy MTJ (56, 60) adjacent to one side of the second MTJ, wherein bottom surfaces of the first dummy MTJ and the second dummy MTJ are not connected to any metal; and
a top electrode (74) on each of the MTJs and dummy MTJs,
**characterised by** a cap layer (78) around the first MTJ, the second MTJ, the first dummy MTJ, and the second dummy MTJ, wherein the cap layer (78) covers the entire top surface of the top electrode on each dummy MTJ directly.

9. The MRAM device of claim 9, further comprising:
a metal interconnection (42) under the first MTJ; and
a first inter-metal dielectric, IMD, layer (40) around the metal interconnection and directly under the first dummy MTJ and the second dummy MTJ.

10. The MRAM device of claim 9, wherein the cap layer (78) is formed on the first IMD layer (40).

11. The MRAM device of one of the claims 8 to 10, wherein the cap layer (78) comprises silicon nitride.

12. The MRAM device of one of the claims 8 to 11, further comprising an air gap (76) enclosed by the cap layer (78) between the first dummy MTJ and the first MTJ.

13. The MRAM device of one of claims 8 to 12, further comprising:
a second IMD layer (80) on the cap layer (78).

## Patentansprüche

1. Magnetoresistive Direktzugriffsspeicher-Vorrichtung (Random Access Memory, MRAM-Vorrichtung), umfassend:
einen ersten magnetischen Tunnelübergang (Magnetic Tunneling Junction, MTJ) (44, 48, 52, 58, 62) und einen zweiten MTJ (44, 48, 52, 58, 62) auf einem Substrat (12);
einen Dummy-MTJ (46, 50, 60) zwischen dem ersten MTJ und dem zweiten MTJ, wobei eine Unterseite des Dummy-MTJ mit keinerlei Metall verbunden ist; und
eine obere Elektrode (74) auf jedem der MTJs und dem Dummy-MTJ,
**gekennzeichnet durch** eine Kappschicht (78) um den Dummy-MTJ, den ersten MTJ und den zweiten MTJ herum, wobei die Kappschicht (78) die gesamte Oberseite der oberen Elektrode auf dem Dummy-MTJ direkt bedeckt.

2. MRAM-Vorrichtung nach Anspruch 1, des Weiteren umfassend:
eine erste Metall-Interconnect-Verbindung (42) unter dem ersten MTJ;
eine zweite Metall-Interconnect-Verbindung (42) unter dem zweiten MTJ; und
eine erste Zwischenmetalldielektrikum-Schicht (Inter-Metal Dielectric, IMD-Schicht) (40) um die erste Metall-Interconnect-Verbindung und die zweite Metall-Interconnect-Verbindung herum und direkt unter dem Dummy-MTJ (46, 50, 60).

3. MRAM-Vorrichtung nach Anspruch 2, wobei die erste IMD-Schicht (40) von der Kappschicht (78) bedeckt ist.

4. MRAM-Vorrichtung nach einem der Ansprüche 1 bis 3, wobei die Kappschicht (78) Siliziumnitrid umfasst.

5. MRAM-Vorrichtung nach einem der Ansprüche 1 bis 4, des Weiteren umfassend einen ersten Luftspalt (76), der von der Kappschicht (78) zwischen dem Dummy-MTJ und dem ersten MTJ umschlossen ist.

6. MRAM-Vorrichtung nach Anspruch 5, des Weiteren umfassend einen zweiten Luftspalt (76), der von der Kappschicht (78) zwischen der Dummy-MTJ und der zweiten MTJ umschlossen ist.

7. MRAM-Vorrichtung nach Anspruch 3, des Weiteren umfassend:
eine zweite IMD-Schicht (80) auf der Kappschicht (78).

8. Magnetoresistive Direktzugriffsspeicher-Vorrichtung (Random Access Memory, MRAM-Vorrichtung), umfassend:
einen ersten magnetischen Tunnelübergang (Magnetic Tunneling Junction, MTJ) (52, 58) und einen zweiten MTJ (52, 58) auf einem Substrat (12), wobei der erste MTJ unmittelbar an den zweiten MTJ grenzt;
einen ersten Dummy-MTJ (56, 60), der an eine Seite des ersten MTJ grenzt;
einen zweiten Dummy-MTJ (56, 60) neben einer Seite des zweiten MTJ, wobei die Unterseiten des ersten Dummy-MTJ und des zweiten Dummy-MTJ mit keinerlei Metall verbunden sind; und
eine obere Elektrode (74) auf jedem der MTJs und Dummy-MTJs,
**gekennzeichnet durch** eine Kappschicht (78) um den ersten MTJ, den zweiten MTJ, den ersten Dummy-MTJ und den zweiten Dummy-MTJ herum, wobei die Kappschicht (78) die gesamte Oberseite der oberen Elektrode auf jedem Dummy-MTJ (74) direkt bedeckt.

9. MRAM-Vorrichtung nach Anspruch 9, des Weiteren umfassend:
eine Metall-Interconnect-Verbindung (42) unter dem ersten MTJ; und
eine erste Zwischenmetalldielektrikum-Schicht (IMD-Schicht) (40) um die Metall-Interconnect-Verbindung (30) herum und direkt unter dem ersten Dummy-MTJ und dem zweiten Dummy-MTJ.

10. MRAM-Vorrichtung nach Anspruch 9, wobei die Kappschicht (78) auf der ersten IMD-Schicht (40) ausgebildet ist.

11. MRAM-Vorrichtung nach einem der Ansprüche 8 bis 10, wobei die Kappschicht (78) Siliziumnitrid umfasst.

12. MRAM-Vorrichtung nach einem der Ansprüche 8 bis 11, des Weiteren umfassend einen Luftspalt (76), der von der Kappschicht (78) zwischen dem Dummy-MTJ und dem ersten MTJ umschlossen ist.

13. MRAM-Vorrichtung nach einem der Ansprüche 8 bis 12, des Weiteren umfassend:
eine zweite IMD-Schicht (80) auf der Kappschicht (78).

## Revendications

1. Dispositif de mémoire vive magnétorésistive (Random Access Memory, MRAM) comprenant :
une première jonction tunnel magnétique (Magnetic Tunneling Junction, MTJ) (44, 48, 52, 58, 62) et une seconde MTJ (44, 48, 52, 58, 62) sur un substrat (12) ;
une MTJ factice (46, 50, 60) entre la première MTJ et la seconde MTJ,
dans lequel une surface inférieure de la MTJ factice n'est reliée à aucun métal ; et
une électrode supérieure (74) sur chacune des MTJ et de la MTJ factice,
**caractérisé par** une couche de recouvrement (78) autour de la MTJ factice, de la première MTJ et de la seconde MTJ, dans lequel la couche de recouvrement (78) recouvre directement la totalité de la surface supérieure de l'électrode supérieure sur la MTJ factice.

2. Dispositif MRAM selon la revendication 1, comprenant en outre :
une première interconnexion métallique (42) sous la première MTJ ;
une seconde interconnexion métallique (42) sous la seconde MTJ ; et
une première couche diélectrique intermétallique (Inter-Metal Dielectric, IMD) (40) autour de la première interconnexion métallique et de la seconde interconnexion métallique et directement sous la MTJ factice (46, 50, 60).

3. Dispositif MRAM selon la revendication 2, dans lequel la première couche IMD (40) est recouverte par la couche de recouvrement (78).

4. Dispositif MRAM selon l'une des revendications 1 à 3, dans lequel la couche de recouvrement (78) comprend du nitrure de silicium.

5. Dispositif MRAM selon l'une des revendications 1 à 4, comprenant en outre un premier entrefer (76) entouré par la couche de recouvrement (78) entre la MTJ factice et la première MTJ.

6. Dispositif MRAM selon la revendication 5, comprenant en outre un second entrefer (76) entouré par la couche de recouvrement (78) entre la MTJ factice et la seconde MTJ.

7. Dispositif MRAM selon la revendication 3, comprenant en outre :
une seconde couche IMD (80) sur la couche de recouvrement (78) .

8. Dispositif de mémoire vive magnétorésistive (Random Access Memory, MRAM) comprenant :
une première jonction tunnel magnétique (Magnetic Tunneling Junction, MTJ) (52, 58) et une seconde MTJ (52, 58) sur un substrat (12), dans lequel la première MTJ est immédiatement adjacente à la seconde MTJ ;
une première MTJ factice (56, 60) adjacente à un côté de la première MTJ ;
une seconde MTJ factice (56, 60) adjacente à un côté de la seconde MTJ, dans lequel des surfaces inférieures de la première MTJ factice et de la seconde MTJ factice ne sont reliées à aucun métal ; et
une électrode supérieure (74) sur chacune des MTJ et des MTJ factices,
**caractérisé par**
une couche de recouvrement (78) autour de la première MTJ, de la seconde MTJ, de la première MTJ factice, et de la seconde MTJ factice, dans lequel la couche de recouvrement (78) recouvre directement la totalité de la surface supérieure de l'électrode supérieure sur chaque MTJ factice.

9. Dispositif MRAM selon la revendication 9, comprenant en outre :
une interconnexion métallique (42) sous la première MTJ ; et
une première couche diélectrique intermétallique (Inter-Metal Dielectric, IMD) (40) autour de l'interconnexion métallique et directement sous la première MTJ factice et la seconde MTJ factice.

10. Dispositif MRAM selon la revendication 9, dans lequel la couche de recouvrement (78) est formée sur la première couche IMD (40).

11. Dispositif MRAM selon l'une des revendications 8 à 10, dans lequel la couche de recouvrement (78) comprend du nitrure de silicium.

12. Dispositif MRAM selon l'une des revendications 8 à 11, comprenant en outre un entrefer (76) entouré par la couche de recouvrement (78) entre la première MTJ factice et la première MTJ.

13. Dispositif MRAM selon l'une des revendications 8 à 12, comprenant en outre :
une seconde couche IMD (80) sur la couche de recouvrement (78) .
